# EUROPEAN PATENT APPLICATION

(11) **EP 2 194 157 A1**
(43) Date of publication of application: **09.06.2010**
(21) Application number: 08828619.0
(22) Date of filing: 20.08.2008
(51) Int. Cl.: C23C 14/08, C23C 14/34, H01B 13/00, H01L 31/04

(54) **METHOD FOR FORMING TRANSPARENT CONDUCTIVE FILM**

(30) Priority: 24.08.2007 JP 2007218296
(71) Applicant: ULVAC, INC., Chigasaki-shi Kanagawa 253-8543 (JP)
(72) Inventor: TAKAHASHI, Hirohisa, Sanmu-shi Chiba 289-1297 (JP); ISHIBASHI, Satoru, Sanmu-shi Chiba 289-1297 (JP); SUGIURA, Isao, Sanmu-shi Chiba 289-1297 (JP); TAKASAWA, Satoru, Sanmu-shi Chiba 289-1297 (JP)
(74) Representative: Eisenführ, Speiser & Partner
(86) International application number: PCT/JP2008/064829
(87) International publication number: WO 2009/028372

(57) **Abstract**

A method for forming a transparent conductive film forms the transparent conductive film containing ZnO as a basic element on a substrate by a sputtering which is performed by applying a sputtering voltage to a target made of a material to form the transparent conductive film and generating a horizontal magnetic field over a surface of the target. The sputtering is performed by setting the sputtering voltage to 340 V or less.

## Description

### Technical Field

The present invention relates to a method for forming a transparent conductive film.
The present application claims priority to Japanese Patent Application No. 2007-218296, the contents of which are incorporated herein by reference.

### Background Art

A transparent conductive material ITO (In₂O₃-SnO₂) is used for electrodes of solar cells or LEDs (Light Emitting Diodes). However, indium (In), the source of ITO, is a rare metal, and the cost thereof is expected to rise in the future due to acquisition difficulties. Therefore, a ZnO based material, which is abundant and inexpensive, is gaining attention as a transparent conductive material that can replace ITO (for example, refer to Patent Document 1 below). The ZnO based material is suitable for sputtering that can form a uniform film on a large substrate. In addition, film-forming can be simply achieved by changing the target of an In₂O₃ based material. Furthermore, unlike the In₂O₃ based material, the ZnO based material does not contain low grade oxide such as InO, which is highly insulating.
[Patent Document 1] Japanese Unexamined Patent Application, First Publication No. H09-87833

### Disclosure of the Invention

### Problem that the Invention is to solve

While the resistance of the ZnO based material is low next to ITO, the typical specific resistance of the ZnO based material is between 500 µΩcm and 1000 µΩcm, which is 2.5 to 5 times that of ITO. Therefore, it is required to further lower the resistance of the ZnO based material.
In addition, if a hot ZnO based material is left in the air, its specific resistance rises due to oxidation. Since the ZnO based material has a low heat resistance as above, there is a problem in that cooling is required before taking a ZnO based film, which is formed by heating in vacuum, into the air.

The present invention has been made to solve the foregoing problems, and has an object of providing a method for forming a transparent conductive film made of a ZnO based material, which has a low specific resistance and excellent heat resistance.

### Means for solving the Problem

The inventors of the present invention found that the specific resistance of a ZnO based film is affected by a sputtering voltage and the strength of a magnetic field while the film is being formed. Although it has been previously known that the specific resistance of the ZnO based film varies greatly with the thickness of the film or the degree of oxidation, the dependence of specific resistance on sputtering voltage and on magnetic field strength had not been confirmed since variations by the thickness of the film or the degree of oxidation have great noise. The inventors of the present invention found, for the first time, the dependence of specific resistance on sputtering voltage and on magnetic field strength in the course of developing a method for forming a thick ZnO based film as a transparent electrode for application in solar cells.

In an aspect of the invention, the method for forming a transparent conductive film may form the transparent conductive film containing ZnO as a basic element on a substrate by a sputtering which is performed by applying a sputtering voltage to a target made of a material to form the transparent conductive film and generating a horizontal magnetic field over a surface of the target. The sputtering may be performed by setting the sputtering voltage to 340 V or less.
In the method for forming a transparent conductive film, the sputtering may be performed by setting a maximum of a strength of the horizontal magnetic field over the surface of the target to 600 gauss or more.
According to the method for forming a transparent conductive film, a ZnO based film in which crystal lattices are arranged in order can be formed, and thus a transparent conductive film having a low specific resistance can be produced. In addition, since the ZnO based film in which crystal lattices are arranged in order is formed, the transparent conductive film having excellent heat resistance, which is rarely oxidized even if heated to a high temperature, can be produced.

In addition, a material, in which an Al-containing substance is added to ZnO, may be used as the material of the target, which will form the transparent conductive film.
In this case, a transparent conductive film, the specific resistance of which is especially low among those of ZnO based films, can be produced.

In addition, the sputtering may be performed while introducing an oxygen gas.
In this case, a transparent conductive film having high optical transmittance can be produced since an oxygen-rich ZnO based film is formed.

In addition, there may be employed a configuration in which a device for generating the horizontal magnetic field includes a first magnet having a first polarity and a second magnet having a second polarity, the first and second magnets arranged on a rear side of the target, and in which the second magnet is arranged to surround the first magnet.
In this case, since a strong horizontal magnetic field can be generated over the surface of the target, a ZnO based film, the crystal lattices of which are arranged in order, can be produced. Accordingly, a transparent conductive film having a low specific resistance and excellent heat resistance can be produced.

In addition, the sputtering may be performed while changing relative positions of a device for generating the horizontal magnetic field and the target.
In this case, the erosion area of the target can be dispersed, thereby improving the endurance of the target.

In addition, the sputtering may be performed while changing relative positions of the substrate and the target.
In this case, a transparent conductive film, which is uniform across the entire area of the substrate, can be produced.

In addition, the sputtering voltage may be applied by using a combination of a direct current power supply and a radio frequency power supply.
In this case, the sputtering voltage can be lowered. This, as a result, makes it possible to form a ZnO based film, the crystal lattices of which are arranged in order, and thus to produce a transparent conductive film having a low specific resistance.

### Advantage of the Invention

According to exemplary embodiments of the invention, it is possible to produce a ZnO based film, the crystal lattices of which are arranged in order, and thus to produce a transparent conductive film having a low specific resistance and excellent heat resistance.

### Brief Description of the Drawings

FIG. 1 is a schematic configuration view showing a magnetron sputtering device according to an exemplary embodiment of the present invention.
FIG. 2 is a plane cross-sectional view of a film-forming chamber.
FIG. 3 is a front elevation view of a sputtering cathode mechanism.
FIG. 4 is a modified example of the magnetron sputtering device.
FIG. 5 is a graph showing the relationship between horizontal magnetic field strength and sputtering voltage.
FIG. 6 is a graph showing the relationship between the thickness and the specific resistance of a ZnO based film.
FIG. 7A is a graph showing the relationship between annealing temperature and specific resistance.
FIG. 7B is a graph showing the relationship between annealing temperature and specific resistance.
FIG. 8 is a graph showing the relationship between sputtering voltage and specific resistance.

### Description of Reference Numerals and Signs

5 SUBSTRATE
10 MAGNETRON SPUTTERING DEVICE
22 TARGET
26 DC POWER SUPPLY (VOLTAGE APPLYING UNIT)
30 MAGNETIC CIRCUIT (MAGNETIC FIELD GENERATING UNIT)
31 FIRST MAGNET
32 SECOND MAGNET

### Best Mode for Carrying out the Invention

A method for forming a transparent conductive film in accordance with an exemplary embodiment of the invention will be described hereinafter with reference to the accompanying drawings.

### (Magnetron Sputtering Device)

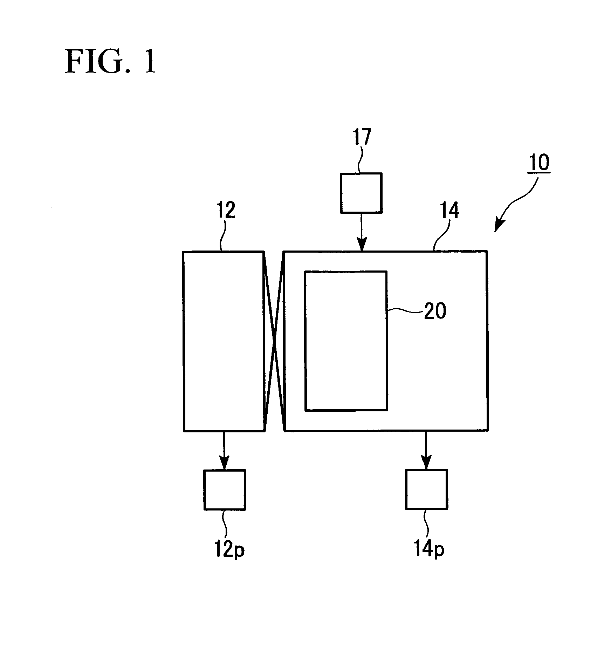

FIG. 1 is a schematic configuration view showing a magnetron sputtering device. The sputtering device 10 of this embodiment is an interback type sputtering device, and includes a substrate (not shown) input/output chamber 12 and a film-forming chamber 14 for the substrate. A rough evacuation unit 12p such as a rotary pump is connected to the input/output chamber 12, and a high-vacuum evacuation unit 14p such as turbo molecular pump is connected to the film-forming chamber 14. In the sputtering device 10 of this embodiment, the substrate, supported in the vertical position, is taken into the input/output chamber 12, which is then evacuated by the rough evacuation unit 12p. Next, the substrate is carried into the film-forming chamber 14, which is evacuated to a complete vacuum by the high-vacuum evacuation unit 14p, and film-forming treatment is performed. After the film-forming treatment, the substrate is taken out through the input/output chamber 12.

A gas supply unit 17, which supplies a sputtering gas such as Ar, is connected to the film-forming chamber 14. The gas supply unit 17 can also supply a reaction gas such as O₂. Inside the film-forming chamber 14, a sputtering cathode mechanism 20 is arranged in the vertical direction.

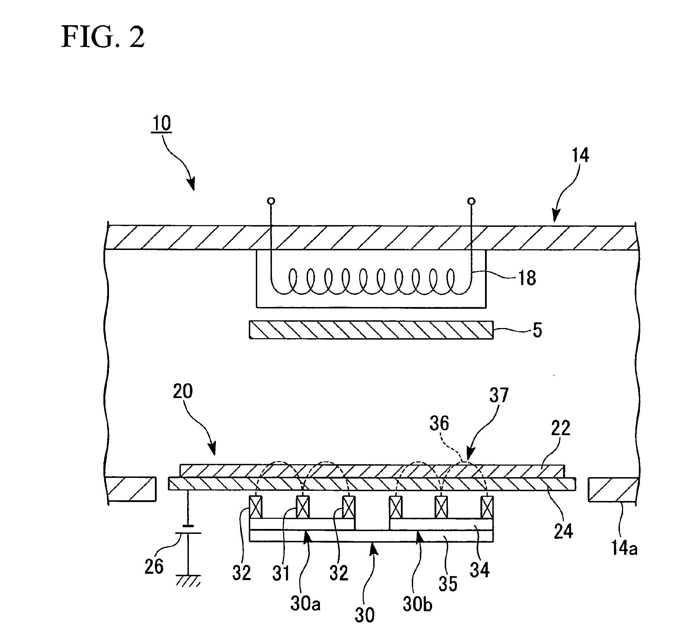

FIG. 2 is a plane cross-sectional view of the film-forming chamber. The sputtering cathode mechanism 20 is arranged adjacent to one side of the film-forming chamber 14 in the width direction thereof. In the other side of the film-forming chamber 14, a heater 18 for heating a substrate 5 is arranged.

The sputtering cathode mechanism 20 mainly includes a target 22, a rear side plate 24, and a magnetic circuit 30. The rear side plate 24 is connected to a DC power supply 26, and is maintained at a negative potential. The target 22, which is a ZnO based film-forming material bonded by a brazing metal, is arranged on the surface of the rear side plate 24. The ZnO based film-forming material can be only ZnO or be produced by adding a specific material to ZnO.
A sputtering gas is supplied from the gas supply unit 17 into the film-forming chamber 14, and a sputtering voltage is applied to the rear side plate 24 by the DC power supply 26. Inside the film-forming chamber 14, ions of the sputtering gas, excited by plasma, collide into the target 22, thereby scattering atoms of a material that will form a ZnO based film. The ZnO based film is formed over the substrate 5 by attaching the scattering atoms onto the substrate 5.

The magnetic circuit 30, which generates a horizontal magnetic field on the surface of the target 22, is arranged along the rear side of the rear side plate 24. The magnetic circuit 30 includes first magnets 31 and second magnets 32, in which the surfaces of the first magnets 31 facing the rear side plate 24 and the surfaces of the second magnets 32 facing the rear side plate 24 have different polarities. All of the first and second magnets 31 and 32 are permanent magnets.

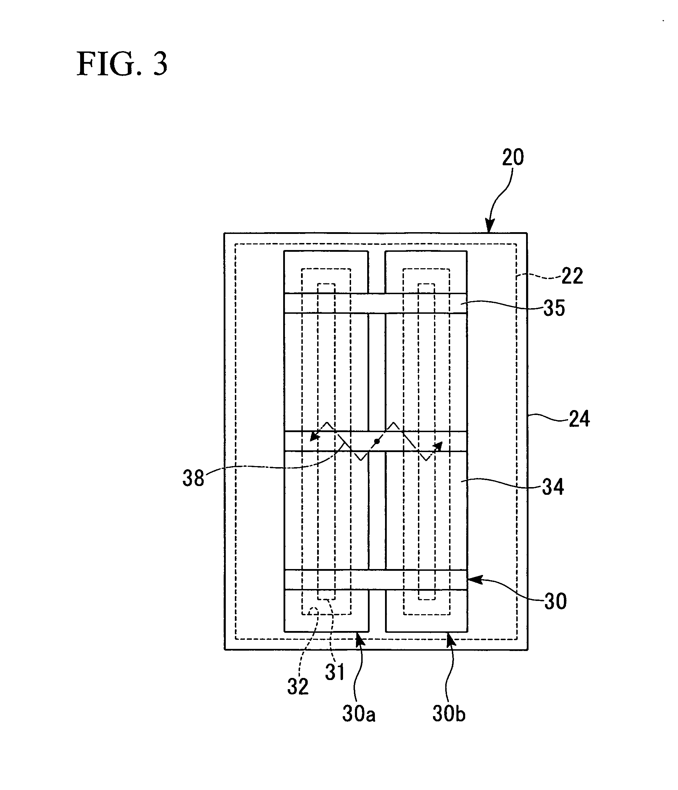

FIG. 3 is a rear view of the sputtering cathode mechanism. The first magnet 31 is linearly shaped, and the second magnet 32 is shaped as a frame that surrounds the first magnet 31 with a predetermined distance from the circumference of the first magnet 31. The first and second magnets 31 and 32 are mounted on a yoke 34, thereby forming a magnetic circuit unit 30a. In addition, a plurality of magnetic circuit units 30a and 30b (two magnetic circuit units in this embodiment) are connected to each other by a bracket 35, thereby forming the magnetic circuit 30.

As shown in FIG. 2, due to the first and second magnets 31 and 32, in which the surfaces of the first magnets 31 facing the rear side plate 24 and the surfaces of the second magnets 32 facing the rear side plate 24 have different polarities, a magnetic field designated by lines of magnetic force 36 is generated. As a result, a position 37 where a vertical magnetic field is 0 (i.e., a horizontal magnetic field is maximum) occurs on the surface of the target 22 between the first and second magnets 31 and 32. By forming high-density plasma on this position 37, the film-forming rate can be accelerated.

In this position 37, the target 22 is eroded to the deepest. The magnetic circuit 30 is provided so as to be movable in the horizontal direction in order to improve the use efficiency (lifespan) of the target by ensuring this position 37 so as not to be fixed, as well as in order to improve arcing by raising the cooling efficiency of the target and the cathode. In addition, the magnetic circuit 30 is set to be movable also in the vertical direction since the upper and lower ends of the target 22 are eroded in the form of a rectangle or a semicircle. Specifically, there is provided a pair of actuators (not shown), which reciprocate the bracket 35 of the magnetic circuit 30, independently in the horizontal and vertical directions. The magnetic circuit 30 is moved along a zigzag path on a plane in parallel with the target 22 by driving the horizontal actuator and the vertical actuator at different cycles.

### (Modified Example)

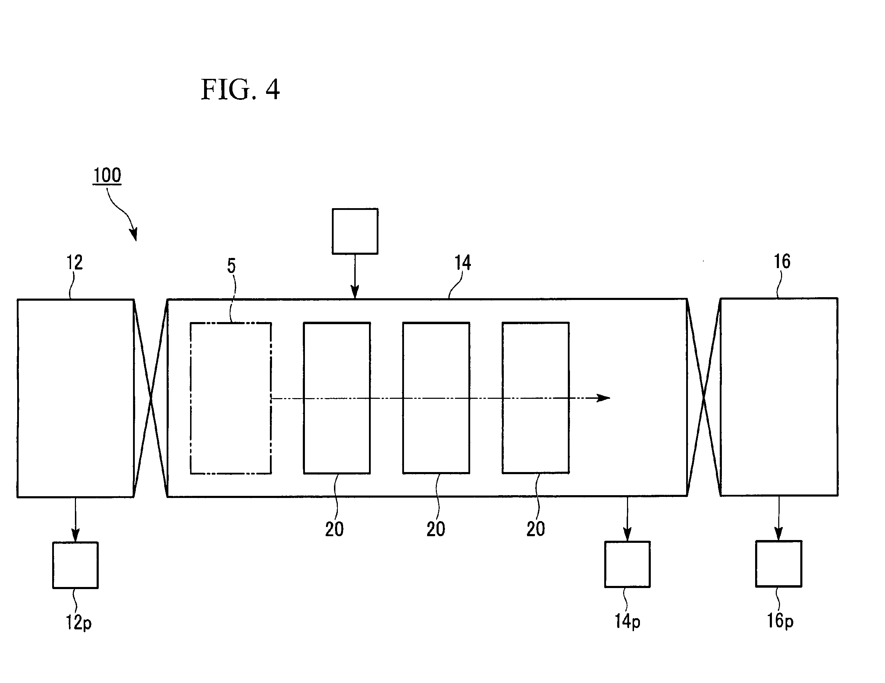

FIG. 4 is a modified example of the magnetron sputtering device. The sputtering device 100 is an in-line type sputtering device, which includes, in sequence, an input chamber 12, a film-forming chamber 14, and an output chamber 16. In the sputtering device 100, the substrate 5 is taken in a vertically-supported position into the input chamber 12, which is then evacuated by the rough evacuation unit 12p. Next, the substrate is carried into the film-forming chamber 14, which is evacuated to a complete vacuum by the high-vacuum evacuation unit 14p, and then film-forming treatment is performed. After the film-forming treatment, the substrate 5 is taken out of the output chamber 16, which is evacuated by the rough evacuation unit 16p.

Inside the film-forming chamber 14, a plurality of sputtering cathode mechanisms 20 (three sputtering cathode mechanisms in this embodiment) are arranged along the direction, in which the substrate 5 is carried. Each of the sputtering cathode mechanisms 20 is configured to be the same as in the above-described embodiment. In this modified example, the sputtering cathode mechanisms 20 forms a ZnO based film over the surface of the substrate 5 while the substrate 5 is passing in front of a plurality of the sputtering cathode mechanisms 20. As a result, the uniform ZnO based film can be formed, and the through-put of the film-forming process can be improved.

### (First Embodiment)

In this embodiment, a ZnO (AZO) film, to which Al is added, is formed using the sputtering device as shown in FIGS. 1 to 3. The ZnO based film shows conductivity since free electrons are emitted due to oxygen holes in the crystal. Since the ZnO based film is vulnerable to oxidation, a heated film-forming treatment is preferable in order to reduce the influence of an oxidation source by degassing. In addition, the conductivity of the ZnO based film can be improved since atoms such as B, Al, Ga, or the like occupying Zn sites in the crystal form ions, thereby emitting free electrons. Even from this point of view, the heated film-forming treatment, in which migration may easily occur, is advantageous.

In the target 22 shown in FIG. 2, ZnO, to which Al₂O₃ is added between 0.5 wt% and 10.0 wt% (2.0 wt% in this embodiment), is used as a material that forms a transparent conductive film. An alkali-free glass substrate 5 is taken into the film-forming chamber 14, and is then heated at a temperature between 100°C and 600°C (200°C in this embodiment) using a heater 18. The film-forming chamber 14 is evacuated to a complete vacuum using the high vacuum evacuation unit, and Ar gas is introduced as a sputtering gas using the gas supply unit so that the pressure of the film-forming chamber 14 is maintained between 2 mTorr and 10 mTorr (5 mTorr in this embodiment). A power having a power density between 1 W/cm² and 8 W/cm² (4 W/cm² in this embodiment) is applied to the rear side plate 24 using the DC power supply 26 while the magnetic circuit 30 is being moved. In addition, although annealing is not performed after film-forming because the film-forming is performed under heating, annealing can still be performed after the film-forming.

As described above, the conductivity of the ZnO based film can be improved since atoms such as B, Al, Ga, or the like occupying Zn sites in the crystal form ions, thereby emitting free electrons. Accordingly, a transparent conductive film, the specific resistance of which is especially low among those of ZnO based films, can be produced by performing sputtering using the ZnO target, in which Al₂O₃ is added, and forming a ZnO (AZO) film, to which Al is added.

The inventors of the present invention estimated the dependence of the specific resistance of ZnO based films on magnetic field strength. For this reaction, ZnO based films were formed at first and second levels. At the first level, the magnetic circuit 30 was adjusted so that the horizontal magnetic field strength on the surface of the target was 300 gauss. At the second level, the magnetic circuit 30 was adjusted so that the horizontal magnetic field strength on the surface of the target was 1500 gauss. Specific resistances were measured by setting the thickness of the ZnO base film to 2000A, 5000Å, 10000Å, and 15000Å with respect to the respective levels.

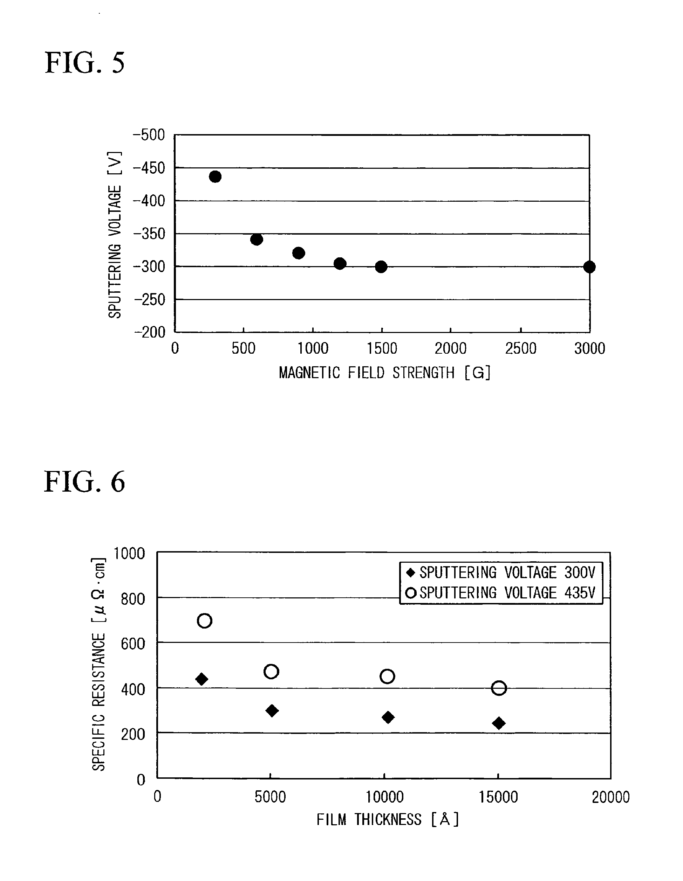

FIG. 5 is a graph showing the relationship between horizontal magnetic field strength and sputtering voltage. As shown in FIG. 5, the relationship is that the higher the horizontal magnetic field strength is, the lower the sputtering voltage is. In general, the sputtering voltage is affected by discharge impedance (= target voltage/target current), which is in turn affected by the magnetic field strength on the surface of the target. If the magnetic field strength increases, the density of plasma also increases, thereby lowering the sputtering voltage. The sputtering voltage of the first level (in which the horizontal magnetic field strength is 300 gauss) is about 450 V, and the sputtering voltage of the second level (in which the horizontal magnetic field strength is 1500 gauss) is about 300 V.

FIG. 6 is a graph showing the relationship between the thickness and the specific resistance of a ZnO based film. Since the specific resistance of a ZnO based material is dependent on the thickness of a film, the specific resistance decreases when the thickness of the film increases.
The specific resistance of a ZnO based film, which is formed at the second level (1500 gauss, 300 V), is lower than that of a ZnO based film, which is formed at the first level (300 gauss, 435 V). The reasons are considered to be as follows: Since specific resistance is dependent on film thickness, the ZnO based material has a property in that crystal lattices are not easily arranged in order. If the ZnO based film is formed using a high sputtering voltage (i.e., a weak magnetic field), the specific resistance increases due to the disordered crystal lattices. Even in this case, a tendency can be seen, in which the crystal lattices are arranged in order due to an increase in the film thickness, thereby decreasing the specific resistance. However, since a method of arranging the crystal lattices in order is not sufficient, the specific resistance increases when compared to that of a thin ZnO based film, which is formed by a low sputtering voltage (i.e., a strong magnetic field).

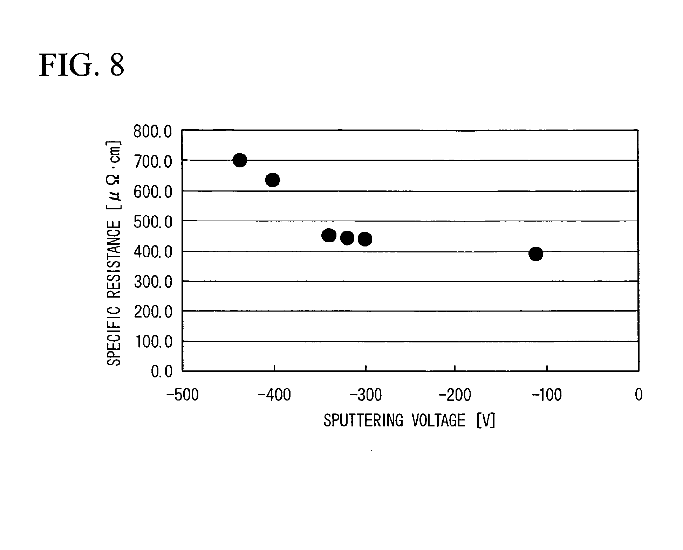

FIG. 8 is a graph showing the relationship between sputtering voltage and specific resistance when a ZnO based film having a thickness 2000A is formed by heating a substrate at a temperature 200°C. (In FIG. 8, the sputtering voltage is illustrated as being a negative potential.) It can be appreciated that the specific resistance is about 400 µΩcm if the absolute value of the sputtering voltage is 340 V or less but the specific resistance drastically increases if the absolute value of the sputtering voltage exceeds 340 V.
Accordingly, it is preferable to form a ZnO based film by sputtering by setting the sputtering voltage to 340 V or less and setting the maximum of the horizontal magnetic field strength on the surface of the target to be 600 gauss or more (see FIG. 5). This, as a result, makes it possible to form a ZnO based film, in which crystal lattices are well ordered, so that the ZnO based film can have a low specific resistance (i.e., the specific resistance is 500 µΩcm or less even if the film is thin). In addition, when sputtering is performed at a low voltage 340 V or less, it is possible to suppress negative ions excited by plasma from being accelerated and rushing into the substrate, which otherwise would cause a damage in a base film or the like.
In addition, the lower limit of the sputtering voltage is a discharge voltage by which sputtering can be enabled. Also, the maximum of the horizontal magnetic field strength is preferably 600 gauss or more as described above. It is preferable that the maximum of the horizontal magnetic field strength is greater since the discharge voltage can be lowered more if the horizontal magnetic field strength is greater. However, since typically permanent magnets are used to generate a magnetic field, the upper limit is determined by the performance of the permanent magnets used.

In addition, the inventors of the present invention estimated the dependence of the heat resistance of ZnO based films on magnetic field strength. Specifically, specific resistance was measured by forming ZnO based films having a thickness 5000Å at first and second levels, followed by annealing at a variety of temperatures after the films were formed. The annealing was performed in a temperature range between 150°C and 600°C (at every 50°C) in the air for 1 hour.

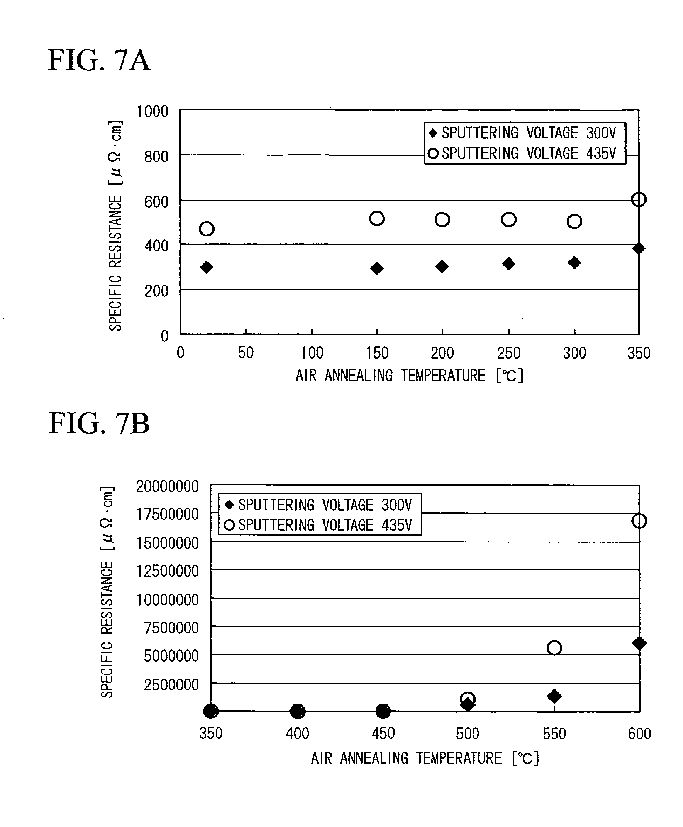

FIGS. 7A and 7B are graphs showing the relationship between annealing temperature and specific resistance, in which FIG. 7A is a graph at a temperature of 350°C or less, and FIG. 7B is a graph at a temperature of 350°C or more. If the annealing temperature is 450°C or less, neither the first level nor the second level showed a significant increase in specific resistance. In contrast, as shown in FIG. 7B, if the annealing temperature is 500°C or more, the specific resistance of the ZnO based film of the second level (1500 gauss, 300 V) is smaller than that of ZnO based film of the first level (300 gauss, 435 V).

The reasons are considered to be as follows: The ZnO based film shows conductivity since free electrons are emitted due to oxygen holes in the crystal. As described above, the crystal lattices of the ZnO based film, formed at a high sputtering voltage (a weak magnetic field), are scattered. The crystal lattices are more likely to bond with oxygen if they are more scattered. Therefore, the ZnO based film, formed at a high sputtering voltage (a weak magnetic field), is apt to be oxidized when annealing is performed at a high temperature after the film-forming. In addition, the specific resistance of the ZnO based film in such a case is higher when compared to that of a ZnO based film formed at a low sputtering voltage (a strong magnetic field).

Accordingly, it is preferable to form a ZnO based film by sputtering at a sputtering voltage set to 340 V or less (or below 340 V) and at the maximum of horizontal magnetic field strength over the surface of the target set to 600 gauss or more. As a result, a ZnO based film, the crystal lattices of which are arranged in order, can be formed. Since the ZnO based film is not easily oxidized even if it is subjected to high temperature annealing after the film-forming, it is possible to suppress specific resistance from rising. That is, the ZnO based film having excellent heat resistance can be produced.
Furthermore, in the case where the substrate is taken out into the air after the heated film-forming treatment, the cooling of the substrate can be excluded or simplified, thereby reducing manufacturing costs.

### (Second Embodiment)

In the second embodiment, an oxygen-rich ZnO based film is formed.
In the target 22 shown in FIG. 2, ZnO is used as a material that will form a transparent conductive film. The alkali-free glass substrate 5 is taken into the film-forming chamber 14, and is heated at a temperature between 100°C and 600°C using the heater 18. The film-forming chamber 14 is evacuated to a complete vacuum by the high vacuum evacuation unit, Ar gas is supplied as a sputtering gas at an amount between 50 sccm and 400 sccm by the gas supply unit, and O₂ gas is supplied at an amount between 0 sccm and 20 sccm as a reaction gas. In addition, the pressure of the film-forming chamber 14 is maintained between 2 mTorr and 10 mTorr. Power is inputted, at a power density between 1 W/cm² and 8 W/cm², into the rear side plate 24 by the DC power supply 26 while the magnetic circuit 30 is being moved.

As such, an oxygen-rich ZnO based film can be formed by sputtering while O₂ gas is being supplied. The oxygen-rich ZnO based film has a high light transmittance even if its specific resistance is great. As a result, a transparent conductive film having excellent optical properties can be produced.

The scope of the present invention is not limited by the certain embodiments as described above. Rather, various changes may be made to the certain embodiments without departing from the spirit of the present invention.
Specific materials or components of the respective embodiments are merely examples and can be properly modified.
For example, although the sputtering is performed by vertically supporting the substrate in the sputtering device of the foregoing embodiments, the present invention can be carried out using a sputtering device that horizontally supports the substrate.
In addition, in the foregoing embodiments, the magnetic circuit unit is constructed by arranging the second magnet of the second polarity around the first magnet of the first polarity. Of course, the magnetic circuit unit can be constructed by arranging a third magnet of the first polarity around the second magnet.

In addition, although the DC power supply is used in the sputtering cathode device of the foregoing embodiments, a Radio Frequency (RF) power supply can be combined with the DC power supply. When only the DC power supply was employed, as shown in FIG. 8, the specific resistance of a ZnO based film (having a film thickness 2000Å), formed using a sputtering voltage 300 V, was 436.6 µΩcm. In contrast, when a DC power supply set to a low current 4 A was combined with an RF power supply of 350 W, the specific resistance of a ZnO based film (having a film thickness 2000Å), formed by using a sputtering voltage 100 V with respect to a ZnO-2wt%Al₂O₃ target, was 389. 4 µΩcm. As such, when the RF power supply is combined with the DC power supply, the sputtering voltage is lowered, and thereby the specific resistance of the ZnO based film is lowered. Accordingly, the resistance of the ZnO based film can be reduced by lowering the magnetic field strength as well as, in terms of power, the sputtering voltage.

### Industrial Applicability

As set forth above, the present invention can provide a method for forming a transparent conductive film made of a ZnO based material, which has a low specific resistance and is excellent in heat resistance.

## Claims

1. A method for forming a transparent conductive film, which forms the transparent conductive film containing ZnO as a basic element on a substrate by a sputtering which is performed by applying a sputtering voltage to a target made of a material to form the transparent conductive film and generating a horizontal magnetic field over a surface of the target,
wherein the sputtering is performed by setting the sputtering voltage to 340 V or less.

2. The method for forming a transparent conductive film according to claim 1,
wherein the sputtering is performed by setting a maximum of a strength of the horizontal magnetic field over the surface of the target to 600 gauss or more.

3. The method for forming a transparent conductive film according to claim 1,
wherein the material of the target, which will form the transparent conductive film, comprises a material in which an Al-containing substance is added to ZnO.

4. The method for forming a transparent conductive film according to claim 1,
wherein the sputtering is performed while introducing an oxygen gas.

5. The method for forming a transparent conductive film according to claim 1,
wherein a device for generating the horizontal magnetic field includes a first magnet having a first polarity and a second magnet having a second polarity, the first and second magnets arranged on a rear side of the target, and
wherein the second magnet is arranged to surround the first magnet.

6. The method for forming a transparent conductive film according to claim 1,
wherein the sputtering is performed while changing relative positions of a device for generating the horizontal magnetic field and the target.

7. The method for forming a transparent conductive film according to claim 1,
wherein the sputtering is performed while changing relative positions of the substrate and the target.

8. The method for forming a transparent conductive film according to claim 1,
wherein the sputtering voltage is applied by using a combination of a direct current power supply and a radio frequency power supply.
